Europäisches Patentamt

European Patent Office

Office européen des brevets

(11) Veröffentlichungsnummer: **0 105 439**
**B1**

# EUROPÄISCHE PATENTSCHRIFT

(45) Veröffentlichungstag der Patentschrift:
03.05.89

(21) Anmeldenummer: **83109565.8**

(22) Anmeldetag: **26.09.83**

(51) Int. Cl.⁴: **H 01 J 37/05,** H 01 J 37/252,
H 01 J 37/10

(54) **Spektrometerobjektiv mit parallelen Objektiv- und Spektrometerfeldern für die Potentialmesstechnik.**

(30) Priorität: **30.09.82  DE 3236273**

(43) Veröffentlichungstag der Anmeldung:
**18.04.84 Patentblatt 84/16**

(45) Bekanntmachung des Hinweises auf die Patenterteilung:
**03.05.89 Patentblatt 89/18**

(84) Benannte Vertragsstaaten:
**DE FR GB NL**

(56) Entgegenhaltungen:
**EP-A- 0 013 876**
**US-A- 3 845 305**
**US-A- 3 870 891**

**PATENTS ABSTRACTS OF JAPAN, Band 6, Nr. 152**
**(P-134) [1030], 12. August 1982; & JP - A - 57 72 072**

(73) Patentinhaber: **Siemens Aktiengesellschaft Berlin und München, Wittelsbacherplatz 2, D-8000 München 2 (DE)**

(72) Erfinder: **Plies, Erich, Dr., Deisenhofener Strasse 79c, D-8000 München 90 (DE)**
Erfinder: **Weyl, Reinhard, Dr., Waldstrasse 16, D-8019 Assling (DE)**
Erfinder: **Lischke, Burkhard, Prof., Dr., In der Heuluss 13, D-8000 München 82 (DE)**

## Beschreibung

Die Erfindung bezieht sich auf ein Spektrometerobjektiv für die Potentialmeßtechnik nach dem Oberbegriff des Patentanspruchs 1.

Aus der Veröffentlichung von H.P. Feuerbaum Scanning Electron Microscopy/1979/I, Seite 285 bis 296, ist ein modifiziertes Rasterelektronmikroskop mit einem zwischen der Objektivlinse und dem zu untersuchenden Bauelement angeordneten Gegenfeldspektrometer bekannt. In einer solchen Konfiguration können die Abbildungsfehler der Objektivlinse nicht durch eine Verringerung der Brennweite reduziert werden, da das Spektrometer einen Mindestarbeitsabstand erzwingt.

Ein Gegenfeldspektrometer mit einer vergleichsweise geringen Bauhöhe ist aus der EP-AI-0 013 876 bekannt.

Der vorliegenden Erfindung liegt die Aufgabe zugrunde, ein Spektrometerobjektiv der eingangs genannten Art anzugeben, mit dem quantitative Potentialmessungen an Leiterbahnen integrierter mikroelektronischer Bauelemente mit einer hohen Orts- und Potentialauflösung durchgeführt werden können. Außerdem soll der Sondenstrom auf der Probe erhöht werden.

Diese Aufgabe wird erfindungsgemäß durch ein Spektrometerobjektiv nach Patentanspruch 1 gelöst. Die Erfindung ermöglicht ein kompaktes neuartiges Spektrometerobjektiv (Objektiv mit integriertem Spektrometer), mit dem eine kleine stromstarke Primär-Elektronensonde und damit eine hohe Ortsauflösung erzielt werden kann. Das erfindungsgemäße Spektrometerobjektiv gewährleistet außerdem eine nahezu winkelunabhängige Detektion der Sekundärelektronen, und damit eine verbesserte Potentialauflösung. Diese verbesserte Leistung wird durch folgende Einzelmaßnahmen erreicht:

a) Die Objektivlinse ist eine «Streufeld-Linse», bei der das magnetische Linsenfeld weitgehend außerhalb des Linsenkörpers liegt. Damit kann man die Forderungen nach einer kleinen Brennweite, nach kleinen axialen Linsenfehlern und nach Platz für das Spektrometer gleichzeitig erfüllen.

b) Das elektrostatische Gegenfeld-Spektrometer ist rotationssymmetrisch und im magnetischen Feld der «Streufeld-Linse» angeordnet, so daß sein elektrisches Feld mit dem magnetischen Linsenfeld räumlich überlagert ist.

c) Die Spektrometer-Elektroden sind so gestaltet, daß zwischen Probe und Gegenfeld-Gitter des Spektrometers das elektrische Feld E des Spektrometers parallel oder antiparallel zur magnetischen Flußdichte B der «Streufeld-Linse» ist; d.h. es soll gelten: $E = cB$ mit c: skalar und $c > 0$ oder $c < 0$.

d) Durch die erfindungsgemäße Ausführungsform des Spektrometers sind die Sekundärelektronen von schädlichen äußeren elektrostatischen Umgebungsfeldern abgeschirmt.

Die «Streufeld-Linse» oder «Schnorchel-Linse» wurde zuerst von T. Mulvey, US-PS 3 870 891, für die Röntgenstrahl-Mikroanalyse vorgeschlagen.

Durch die räumliche Überlagerung von E-Feld und B-Feld bei der erfindungsgemäßen Vorrichtung wirken beide Felder sowohl auf die Primärelektronen, d.h. bei der Primär-Elektronensonden-Erzeugung, als auch auf die Sekundärelektronen, d.h. bei der Potentialmessung. Die erfindungsgemäße Vorrichtung besitzt doppelt-funktionelle Felder für Primär- und Sekundärstrahl.

Bei der erfindungsgemäßen Vorrichtung sind elektrische Potentialflächen senkrecht zu den B-Feldlinien. Dieser Umstand ist günstig für die Detektion der Sekundärelektronen. Wenn elektrische Potentialflächen senkrecht zu B-Feldlinien sind, verschwindet nämlich die $\vec{E} \times \vec{B}$-Drift für die Elektronenbewegung, die ansonsten die Elektronen mit der Driftgeschwindigkeit $\vec{v}_D = \vec{E} \times \vec{B} / |B|^2$ senkrecht sowohl zum E-Feld als auch zum B-Feld abdriften ließe. Sieht man von der noch verbleibenden, aber um eine Größenordnung kleineren Drift infolge von Trägheits- und Feldlinienkrümmungs-Effekten ab, so führen die Sekundärelektronen nur eine Gyrationsbewegung aus. Dies bedeutet, daß die Sekundärelektronen Lamor'sche Kreise beschreiben, deren Mittelpunkt (das Führungszentrum) längs der B-Feldlinie zur Gegenfeld-Elektrode des Spektrometers wandert und diese Gegenfeld-Elektrode näherungsweise senkrecht trifft. Man erhält also eine näherungsweise winkelunabhängige Detektion der Sekundärelektronen für alle Startpunkte von Sekundärelektronen auf der Probe.

Ausgestaltungen und Vorteile der Erfindung sind in den abhängigen Ansprüchen, der Beschreibung und der Zeichnung dargestellt.

Ausführungsbeispiele der Erfindung werden im folgenden anhand der Zeichnung näher erläutert.

Fig. 1 zeigt die axiale Feldverteilung einer «Schnorchel-Linse».

Fig. 2 zeigt elektrische Äquipotentialflächen, für die das vektorielle Produkt aus E-Feld und dem B-Feld nach Fig. 1 verschwindet.

Fig. 3 mit Fig. 5 zeigen erfindungsgemäße Spektrometerobjektive.

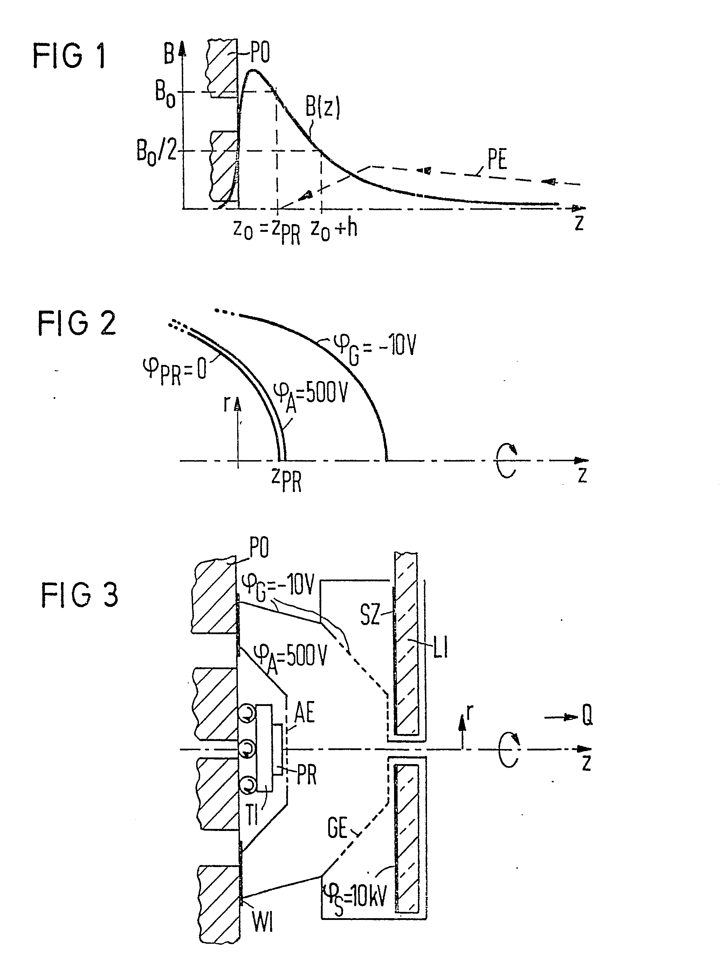

Fig. 1 zeigt die axiale Feldverteilung B(z) einer «Schnorchel-Linse», wie sie beispielsweise in der obengenannten Patentschrift von Mulvey beschrieben worden ist. Diese «Schnorchel-Linse» besitzt Polschuhe PO, aus denen das magnetische Feld B(z, r) austritt. Anhand der Zeichnung wird demonstriert, wie man aus einer gemessenen axialen Feldverteilung B(z) einer «Streufeld-Linse» die Form von Absaugelektrode AE und Gegenfeld-Elektrode GE eines erfindungsgemäßen Spektrometerobjektivs bestimmt, so daß die E-Feldlinien näherungsweise parallel bzw. antiparallel zu den B-Feldlinien verlaufen.

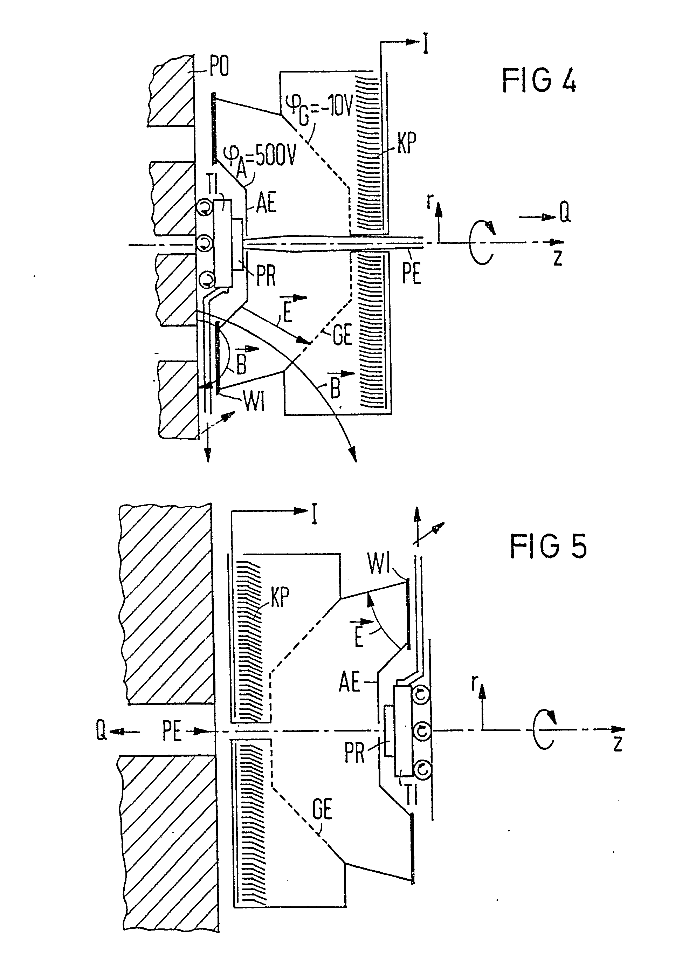

Die drei Figuren 3, 4 und 5 zeigen drei verschiedene Ausführungsformen eines erfindungsgemäßen Spektrometerobjektivs. Bei den Fig. 3 und 4 kommt der Primärstrahl PE von der Feldseite der Schnorchel-Linse, während der Primärstrahl PE in Fig. 5 von der Eisenkreisseite der Schnorchel-Linse einfällt. In Fig. 3 ist der Detektor ein Szintilator SZ mit Lichtleiter LI. Die Absaugelektrode AE

ist in Fig. 3 in Nähe der Probe PR gitterfrömig, und die Enden der Absaugelektrode AE setzen über eine Widerstandsschicht WI und einen in der Figur nicht dargestellten Isolator auf den Polschuhen PO der Schnorchel-Linse auf. Bei den Ausführungsbeispielen nach Fig. 4 und Fig. 5 ist eine Kanalplatte KP als Detektor gewählt. Die Absaugelektrode AE ist bei den Ausführungsbeispielen nach Fig. 4 und Fig. 5 in Nähe der Probe PR eine Lochblende, und das Spektrometer setzt bei den Ausführungsbeispielen nach Fig. 4 und Fig. 5 mit seiner Widerstandsschicht WI nicht auf den Polschuhen auf.

Im folgenden wird gezeigt, daß und wie aus der gemessenen axialen Feldverteilung B(z) einer Schnorchel-Linse nach Fig. 1 die Lage und die Form der Spektrometer-Elektroden AE, GE bestimmt werden können, so daß die Feldlinien sowohl des E-Feldes als auch des B-Feldes im Spektrometerobjektiv näherungsweise parallel bzw. antiparallel sind. Die Schnorchel-Linse wurde ausgewählt, weil sie bekannterweise kleine axiale Bildfehler besitzt.

Die Fig. 1 zeigt die Feldseite der Schnorchel-Linse mit den Polschuhen PO mit der gemessenen axialen Feldverteilung $B(z) = B_z(z, o)$. Wie man aus Fig. 1 sieht, kann die Meßkurve B(z) für z-Werte größer als $z_o$ sehr gut durch eine Exponentialfunktion approximiert werden. Kommen in Fig. 1 die Primärelektronen PE von rechts und liegt die Sonde bei z-Werten größer als $z_o = z_{PR}$, wobei die Probe PR bei $z_{PR}$ angeordnet ist, so kann eine exponentielle Fitkurve für eine erfindungsgemäße Berechnung des elektrostatischen Potentials für das Spektrometer verwendet werden.

Die gemessene axiale Feldverteilung der Schnorchel-Linse habe bei $z_o$ den Wert $B_o$ und bei $z_o + h$ den Wert $B_o/2$. Bei einem Experiment wurde beispielsweise eine Schnorchel-Linse mit den Werten $B_o$: $4,10^{-2}$ Vsm$^{-2}$ (400 Gauß), $z_o$: 12,5 mm und h: 13 mm verwendet.

Der Umstand, daß das E-Feld parallel bzw. antiparallel zum B-Feld ist, läßt sich mathematisch folgendermaßen ausdrücken:

$$\vec{E}(z, r) = C_1 \cdot \vec{B}(z, r) \qquad (1)$$

Die Bedingung der Gleichung (1) muß auch auf der optischen Achse (r = 0) gelten, wo wegen der vorausgesetzten Rotationssymmetrie nur die z-Komponente der Felder verschieden von Null ist:

$$E_z(z, o) = C_1 \cdot B_z(z, o) \qquad (2)$$

Bezeichnet man mit φ(z, r) das elektrostatische Potential im Raum und mit $\emptyset(z = \varphi(z, o)$ das Potential auf der optischen Achse, so ergibt sich wegen $B_z(z, o) = B(z)$ aus Gleichung (2):

$$-\partial\emptyset(z)/\partial_z = C_1 \cdot B(z) \qquad (3)$$

Durch Integration erhält man aus Gleichung (3) das Achsenpotential:

$$\emptyset(z) = -C_1\int B(z)\, dz + C_2 \qquad (4)$$

mit der Integrationskonstanten $C_2$. Kennt man aber bei Rotationssymmetrie das Potential $\emptyset(z)$ auf der optischen Achse, so kann man das Potential φ(z, r) mit der bekannten Formel

$$\varphi(z, r) = \frac{1}{2\pi} \int_{0}^{2\pi} \emptyset(z + i\, r \sin\alpha)\, d\alpha \qquad (5)$$

im ganzen Raum berechnen. In Gleichung (5) ist i die imaginäre Einheit.

Für die Fitfunktion der experimentell gemessenen axialen Feldverteilung B(z) nach Fig. 1:

$$B(z) = B_o \exp\left[-(z-z_o)\ln 2/h\right] \qquad (6)$$

aus Fig. 1 können die beiden Integrationen in den Gleichungen (4) und (5) sofort ausgeführt werden und man erhält:

$$\varphi(z, r) = C_1 \cdot B_o \cdot a \cdot \exp\left(\frac{z-z_o}{a}\right) J_o\left(\frac{r}{a}\right) + C_2 \qquad (7)$$

mit a = h / ln 2.

Dabei ist in Gleichung (7) $J_o$ die Besselfunktion nullter Ordnung und erster Art. Zur Berechnung der Äquipotentialflächen löst man zweckmäßigerweise Gleichung (7) nach z auf:

$$z = z_o + a \ln\left[\frac{C_1 B_o a}{\varphi - C_2} J_o\left(\frac{r}{a}\right)\right] \qquad (8)$$

Mit Gleichung (8) wurden die Äquipotentialflächen für die Elektroden AE, GE bei den Ausführungsbeispielen nach Fig. 3 und Fig. 4 berechnet mit $z_{PR} = z_o$. Für die erfindungsgemäßen Spektrometeranordnungen nach Fig. 3 und Fig. 4 wurden diese Äquipotentialflächen stückweise durch Ebenen und Kegelstumpf-Mantelflächen ersetzt.

Im Spektrometerobjektiv nach Fig. 3 muß das Gegenfeld-Gitter GE genügend engmaschig und genügend entfernt vom Szintillator SZ gewählt werden, damit die am Szintillator SZ anliegende Spannung von 10 kV nicht durch das Gegenfeld-Gitter GE durchgreift.

Der Primär-Elektronenstrahl PE kann in einfacher Weise über die Probe PR gerastert werden, wenn man ein zweistufiges Strahlablenksystem verwendet und bei den Spektrometerobjektiven nach Fig. 3 und Fig. 4 den Kipp- oder Pivotpunkt der Primär-Elektronenstrahlrasterung in das Primärstrahl-Eintrittsloch im Gegenfeld-Gitter GE legt. Dies ist auch möglich, wenn eine Hauptebene des Objektivs für die Primär-Strahlrasterung zwischen Gegenfeld-Gitter GE und Quelle Q der Primärelektronen PE liegt.

Bei den Ausführungsbeispielen nach Fig. 3 mit Fig. 5 wurden folgende Potentiale gewählt: Die Probe PR befinde sich auf dem Potential $\varphi_{PR} = 0$, die Absaugelektrode AE befinde sich auf einem Potential $\varphi_A = 500$ V, die Gegenfeld-Elektrode GE befinde sich schließlich auf einem Potential $\varphi_G = -10$ V (siehe Fig. 2). In Fig. 4 ist demonstriert, daß die Feldlinien des E-Feldes und des B-Feldes im Spektrometerbereich näherungsweise parallel bzw. antiparallel zueinander verlaufen. In Fig. 4 ist außerdem die Begrenzung und Fokussierung der Primärelektronen PE dargestellt. Bei den Ausführungsbeispielen nach Fig. 4 und Fig. 5 befindet sich die Probe PR jeweils auf einem in der Ebene senkrecht zur optischen Achse verschiebbaren Tisch TI. Die axial durchbohrte Kanalplatte KP nach Fig. 4 und Fig. 5 liefert den Detektorstrom I.

**Patentansprüche**

1. Spektrometerobjektiv für die Potentialmeßtechnik mit einer Objektivlinse zur Fokussierung eines Elektronenstrahls (PE) auf eine Probe (PR), einem Detektor zum Nachweis der auf der Probe (PR) ausgelösten Sekundärelektronen und einem Spektrometer, das eine die Sekundärelektronen beschleunigende erste Elektrode (AE) und eine ein elektrisches Gegenfeld erzeugende zweite Elektrode (GE) aufweist, dadurch gekennzeichnet, daß die Objektivlinse eine magnetische Linse mit einem weitgehend außerhalb des Linsenkörpers liegenden Magnetfeld (B) ist, daß das Spektrometer im Magnetfeld (B) der Objektivlinse angeordnet ist und daß die erste (AE) und die zweite Elektrode (GE) des Spektrometers derart geformt sind, daß die Äquipotentialflächen des elektrischen Gegenfeldes (E) annähernd senkrecht zu den magnetischen Feldlinien (B) orientiert sind.

2. Spektrometerobjektiv nach Anspruch 1, dadurch gekennzeichnet, daß die elektrischen Feldvektoren ($\vec{E}$) annähernd parallel zu den magnetischen Feldvektoren ($\vec{B}$) orientiert sind.

3. Spektrometerobjektiv nach Anspruch 1, dadurch gekennzeichnet, daß die elektrischen Feldvektoren ($\vec{E}$) annähernd antiparallel zu den magnetischen Feldvektoren ($\vec{B}$) orientiert sind.

4. Spektrometerobjektiv nach einem der Ansprüche 1 bis 3, dadurch gekennzeichnet, daß eine Elektronenquelle (Q) auf der Feldseite der magnetischen Linse angeordnet ist.

5. Spektrometerobjektiv nach einem der Ansprüche 1 bis 3, dadurch gekennzeichnet, daß eine Elektronenquelle (Q) auf der Eisenkreisseite der magnetischen Linse angeordnet ist.

6. Spektrometerobjektiv nach einem der Ansprüche 1 bis 5, dadurch gekennzeichnet, daß die erste Elektrode (AE) eine Gitterelektrode ist.

7. Spektrometerobjektiv nach einem der Ansprüche 1 bis 5, dadurch gekennzeichnet, daß die erste Elektrode (AE) eine Lochblende ist.

8. Spektrometerobjektiv nach einem der Ansprüche 1 bis 7, dadurch gekennzeichnet, daß der Detektor einen Szintillator (SZ) und einen Lichtleiter (LI) aufweist.

9. Spektrometerobjektiv nach einem der Ansprüche 1 bis 7, gekennzeichnet durch eine Kanalplatte (KP) als Detektor.

**Claims**

1. Spectrometer objective for the potential measuring technique comprising an objective lens for focusing an electron beam (PE) onto a specimen (PR), a detector for detecting the secondary electrons released on the specimen (PR), and a spectrometer, which has a first electrode (AE), which accelerates the secondary electrons, and a second electrode (GE), which generates an opposing electric field, characterized in that the objective lens is a magnetic lens having a magnetic field (B) which lies largely outside the lens body, in that the spectrometer is arranged in the magnetic field (B) of the objective lens, and in that the first (AE) and the second (GE) electrode of the spectrometer are formed in such a way that the equipotential surfaces of the opposing electric field (E) are oriented approximately perpendicular to the magnetic field lines (B).

2. Spectrometer objective according to Claim 1, characterized in that the electric field vectors ($\vec{E}$) are oriented approximately parallel to the magnetic field vectors ($\vec{B}$).

3. Spectrometer objective according to Claim 1, characterized in that the electric field vectors ($\vec{E}$) are oriented approximately anti-parallel to the magnetic field vectors ($\vec{B}$).

4. Spectrometer objective according to one of Claims 1 to 3, characterized in that an electron source (Q) is arranged on the field side of the magnetic lens.

5. Spectrometer objective according to one of Claims 1 to 3, characterized in that an electron source (Q) is arranged on the iron circuit side of the magnetic lens.

6. Spectrometer objective according to one of Claims 1 to 5, characterized in that the first electrode (AE) is a grid electrode.

7. Spectrometer objective according to one of Claims 1 to 5, characterized in that the first electrode (AE) is a pinhole aperture.

8. Spectrometer objective according to one of Claims 1 to 7, characterized in that the detector has a scintillator (SZ) and a light guide (LI).

9. Spectrometer objective according to one of Claims 1 to 7, characterized by a channel plate (KP) as detector.

**Revendications**

1. Objectif-spectromètre pour la technique de mesure de potentiels, comprenant une lentille de l'objectif pour la focalisation d'un faisceau d'électrons (PE) sur un échantillon (PR), un détecteur pour détecter des électrons secondaires dont l'émission a été provoquée sur l'échantillon (PR), ainsi qu'un spectromètre qui présente une première électrode (AE) accélérant les électrons secondaires et une seconde électrode (GE) créant un champ électrique inverse, caractérisé en ce que la lentille de l'objectif est une lentille magnétique avec un champ magnétique (B) s'étendant largement à l'extérieur du corps de la lentille, que le spectromètre est disposé dans le champ magnétique (B) de la lentille de l'objectif et que la première (AE) et la seconde électrode (GE) du spectromètre sont conformées de manière que les surfaces équipotentielles du champ électrique inverse (E) soient orientées à peu près perpendiculairement aux lignes de force du champ magnétique (B).

2. Objectif-spectromètre selon la revendication 1, caractérisé en ce que les vecteurs de champ électrique ($\vec{E}$) sont orientés à peu près parallèlement aux vecteurs du champ magnétique ($\vec{B}$).

3. Objectif-spectromètre selon la revendication 1, caractérisé en ce que les vecteurs du champ électrique ($\vec{E}$) ont une orientation approximativement antiparallèle par rapport aux vecteurs du champ magnétique ($\vec{B}$).

4. Objectif-spectromètre selon une des revendications 1 à 3, caractérisé en ce qu'une source d'électrons (Q) est disposée du côté champ de la lentille magnétique.

5. Objectif-spectromètre selon une des revendications 1 à 3, caractérisé en ce qu'une source d'électrons (Q) est disposée du côté circuit de fer de la lentille magnétique.

6. Objectif-spectromètre selon une des revendications 1 à 5, caractérisé en ce que la première électrode (AE) est une électrode en forme de grille.

7. Objectif-spectromètre selon une des revendications 1 à 5, caractérisé en ce que la première électrode (AE) est un diaphragme à orifice.

8. Objectif-spectromètre selon une des revendications 1 à 7, caractérisé en ce que le détecteur comporte un scintillateur (SZ) et une fibre optique (LI).

9. Objectif-spectromètre selon une des revendications 1 à 7, caractérisé par une plaque à canal (KP) en tant que détecteur.

FIG 1

FIG 2

FIG 3

FIG 4

FIG 5